# DEMANDE DE BREVET EUROPEEN

(11) **EP 4 567 869 A1**
(43) Date de publication de la demande: **11.06.2025**
(21) Numéro de dépôt: 24217287.2
(22) Date de dépôt: 03.12.2024
(51) Int. Cl.: H01L 21/56, H01L 23/31, H01L 23/00

(54) **PROCEDE DE FABRICATION DE COMPOSANTS ELECTRONIQUES**

(30) Priorité: 08.12.2023 FR 2313867
(71) Demandeur: STMicroelectronics International N.V., 1228 Plan-les-Ouates, Geneva (CH)
(72) Inventeur: DELACOURT, Gregoire, 37000 TOURS (FR)
(74) Mandataire: Cabinet Beaumont

(57) **Abrégé**

La présente description concerne un procédé de fabrication de composants électroniques à flancs mouillables à partir d'un substrat (301) dans lequel sont formées des puces, les puces étant séparées par des cavités, le procédé comprenant une première étape au cours de laquelle une couche de matériau isolant (121) est déposée puis une deuxième étape au cours de laquelle une couche de matériau conducteur (122) est déposée sur la couche de matériau isolant (121) afin de former des flancs mouillables.

## Description

### Domaine technique

La présente description concerne la fabrication de composants électroniques. Elle vise plus particulièrement la fabrication de composants dits à montage en surface, dits "leadless", c'est-à-dire sans connexions apparentes une fois assemblés sur la carte électronique. Ces composants comportent, du côté d'au moins une face, une ou plusieurs métallisations de connexion destinées à être brasées à des plages de connexion correspondantes d'un dispositif externe, par exemple une carte de circuit imprimé ou un autre composant.

### Technique antérieure

Dans certaines applications, il existe un besoin pour des composants à montage en surface dans lesquels des métallisations de connexion destinées à être brasées à un dispositif externe s'étendent jusqu'aux flancs des composants. On parle de composants à flancs mouillables (en anglais "wettable flank"). Lors du montage du composant dans son environnement (par exemple, sur une carte de circuit imprimé), les métallisations de connexion (aussi appelées contacts électriques) sont soudées ou brasées à des pistes ou éléments métalliques correspondants côté circuit imprimé. Une partie du matériau de brasage remonte alors sur les flancs des composants, ce qui permet de mettre en oeuvre une inspection visuelle de la qualité des connexions.

Ce besoin existe par exemple dans le domaine automobile ou le domaine médical et, plus généralement, dans les domaines où l'on souhaite s'assurer du bon assemblage des composants dont les connexions ne sont pas visibles (les connexions sont sous le composant) et garantir la fiabilité des connexions électriques, une fois les circuits montés dans leur environnement.

### Résumé de l'invention

Il existe un besoin d'améliorer au moins en partie certains aspects des procédés connus de fabrication de composants électroniques à flancs mouillables.

Ce but est atteint par un procédé de procédé de fabrication de composants électroniques à flancs mouillables à partir d'un substrat dans lequel sont formées des puces, les puces étant séparées par des cavités, le procédé comprenant une première étape au cours de laquelle une couche de matériau isolant est déposée dans les cavités puis une deuxième étape au cours de laquelle une couche de matériau conducteur est déposée sur la couche de matériau isolant afin de former des flancs mouillables.

Selon un mode de réalisation, les puces comprennent au moins deux plages de connexion, recouvertes par des plots de connexion et disposées sur une première face principale du substrat, et, lors de la première étape, la couche de matériau isolant est déposée dans les cavités, sur les plots métalliques et sur la première face du substrat.

Selon un mode de réalisation, le procédé comprend, avant la deuxième étape, une étape au cours de laquelle une partie de la résine isolante présente dans les cavités est retirée, de manière à former des tranchées dont le fond et les parois sont en résine isolante et, lors de la deuxième étape, la couche de matériau conducteur est déposée dans les tranchées.

Selon un mode de réalisation, le procédé comprend en outre les étapes suivantes :
- Amincir la couche de matériau isolant pour rendre accessibles les plots métalliques,
- Séparer les composants électroniques en découpant le substrat à travers la couche de matériau conducteur.

Ce but est également atteint par un composant électronique à flancs mouillables comprenant une puce protégée par un boîtier dont les flancs comprennent successivement une couche de matériau isolant et une couche de matériau conducteur.

Selon un mode de réalisation, le composant électronique comprend une première face principale comprenant au moins deux plots de connexion, une deuxième face principale et des flancs, la couche de matériau conducteur étant isolée électriquement des plots de connexion par la couche de matériau isolant, la couche de matériau conducteur s'étendant sur une portion des flancs à partir de la première face principale.

Selon un mode de réalisation, la couche de matériau isolant recouvre la première face principale de la puce entre les plots de connexion.

Selon un mode de réalisation, la couche de matériau isolant est une couche de résine époxy ou phénolique dans laquelle sont dispersées des charges électriquement isolantes, par exemple des particules d'alumine.

Selon un mode de réalisation, la couche de matériau conducteur est une couche de résine époxy ou phénolique dans laquelle sont dispersées des charges électriquement conductrices, par exemple des particules d'argent, de cuivre ou de noir de carbone.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et en coupe, un composant électronique à flancs mouillables selon un mode de réalisation particulier ;
la figure 2A, la figure 2B, la figure 2C, la figure 2D, la figure 2E, la figure 2F et la figure 2G représentent des vues en coupe illustrant des étapes d'un procédé de fabrication d'un composant électronique à flanc mouillable selon un mode de réalisation particulier ;
la figure 3A et la figure 3B représentent des vues en coupe illustrant des étapes d'un procédé d'assemblage d'un composant électronique à flanc mouillable avec un dispositif externe selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les composants électroniques trouvent des applications dans de nombreux domaines industriels, et en particulier, dans le domaine automobile ou le domaine médical.

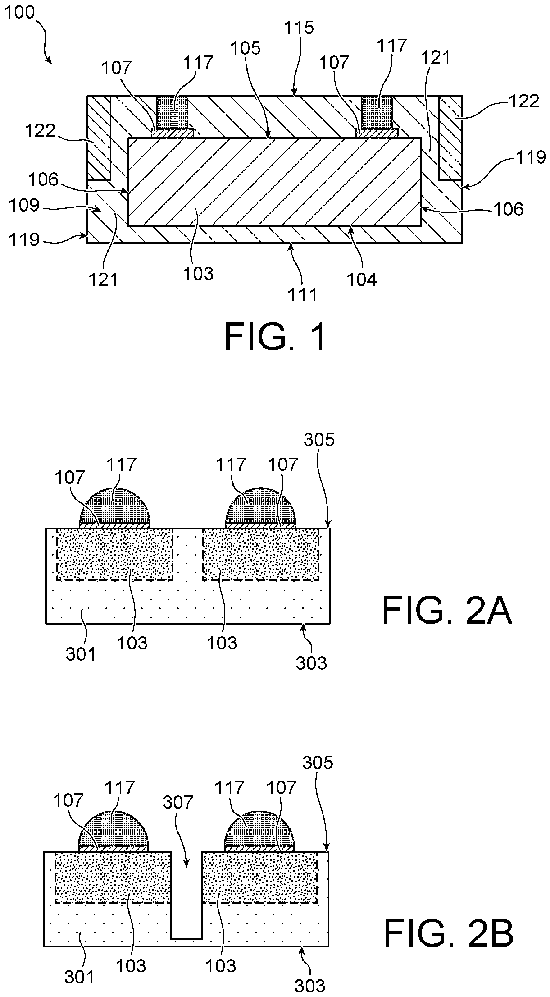

La figure 1 illustre, par une vue en coupe, partielle et schématique, un composant électronique 100 à connexions non débouchantes.

Le composant électronique 100 est formé d'une puce électronique 103 et d'un boîtier 109. Selon un exemple, la puce électronique 103 est formée à partir d'un substrat semiconducteur, par exemple en silicium. Il peut également s'agir de SiC.

La puce comprend une face avant 105 (aussi appelée première face ou face avant ou encore face supérieure), une face arrière 104 (aussi appelée deuxième face ou face arrière ou encore face inférieure) et des flancs 106 (aussi appelés faces latérales). La face inférieure 104 est opposée à la face supérieure 105.

Une ou plusieurs plages de connexion 107 (aussi appelés contacts électriques) sont formées sur la face supérieure 105 de la puce électronique 103 et permettent de la connecter à d'autres éléments (puces ou dispositifs électroniques).

Les plages de connexion électrique 107 sont, par exemple, à une distance de 10 à 30 µm de la paroi latérale de la puce. Les plages de connexion électrique 107 peuvent être positionnées sur la face supérieure 105 de la puce 103 ou affleurer la face supérieure (i.e. arriver au niveau de la face supérieure 105 de la puce 103).

Les plages de connexion électriques 107 sont aussi appelés « UBM » (pour l'expression anglo-saxonne « Under Bump Metallization ») ou « bumping pads ». Les plages de connexion électriques 107 sont en un matériau conducteur spécifiquement adapté à recevoir des plots de connexion 117, et présentant notamment une bonne adhérence avec les plots de connexion 117. Les plages de connexion électriques 107 comprennent au moins un des éléments suivants : or, titane, nickel, cuivre ou tungstène. De préférence, elles comprennent de l'or.

La puce 103 peut comprendre un composant discret ou plusieurs composants discrets. Le ou les composants discrets sont, par exemple, choisis parmi les transistors, diodes, thyristors, triacs, filtres, etc. La puce 103 peut comprendre un ou plusieurs circuits électroniques. La puce 103 permet de mettre en oeuvre différentes fonctions électroniques.

Le composant 100 est un composant dit intégré.

La puce 103 est protégée par le boîtier 109. Plus particulièrement, le boîtier 109 recouvre au moins la face supérieure 105 et les flancs 106 de la puce 103. Selon une variante non représentée, le boîtier 109 peut également recouvrir la face inférieure 104 de la puce 103.

Le boitier 109 est en un matériau isolant électriquement.

Pour pouvoir connecter le composant 100 à d'autres composants et/ou circuits électroniques, le boîtier 109 comprend, en outre, des plots de connexion 117 (aussi appelés contacts du boîtier ou reprises de contacts). Les plots de connexion 117 sont positionnés sur la face supérieure 105 de la puce 103. Chaque plot de connexion 117 est relié à une plage de connexion électriques 107 de la puce 103.

Les plots de connexion 117 sont formés en un matériau conducteur électriquement et "mouillable" (i.e. brasable), c'est-à-dire un matériau sur lequel il est possible de réaliser un brasage.

Les plages de connexion électriques 107 de la puce 103 et les reprises de contacts 117 sont positionnées dans des ouvertures d'une couche de matériau isolant 121 revêtant la puce 103. La couche 121 est, de préférence, une couche en résine isolante.

Le composant est un composant à flanc mouillable, c'est-à-dire qu'au moins une partie des flancs 119 du boîtier 109 est recouverte par une couche de matériau conducteur 122 en un matériau mouillable, c'est-à-dire un matériau sur lequel il est possible de braser.

La couche 122 recouvre partiellement les flancs 119 du boîtier 109 depuis la face supérieure.

La couche 122 est, de préférence, une couche en résine conductrice.

La couche conductrice 122 recouvre partiellement la couche isolante 121. Elle est isolée électriquement des reprises de contact 117 par la couche de matériau isolant 121.

Le dispositif à flancs mouillables permet de visualiser facilement si le brasage du composant sur un autre dispositif a été réalisé correctement.

Nous allons maintenant décrire le procédé de fabrication de composants électroniques à flancs mouillables. Ce procédé comprend une étape au cours de laquelle une couche de matériau isolant 121 est déposée sur les flancs des composants électroniques 100 puis une étape au cours de laquelle une couche de de matériau conducteur 122 est déposée sur la couche de matériau isolant 121.

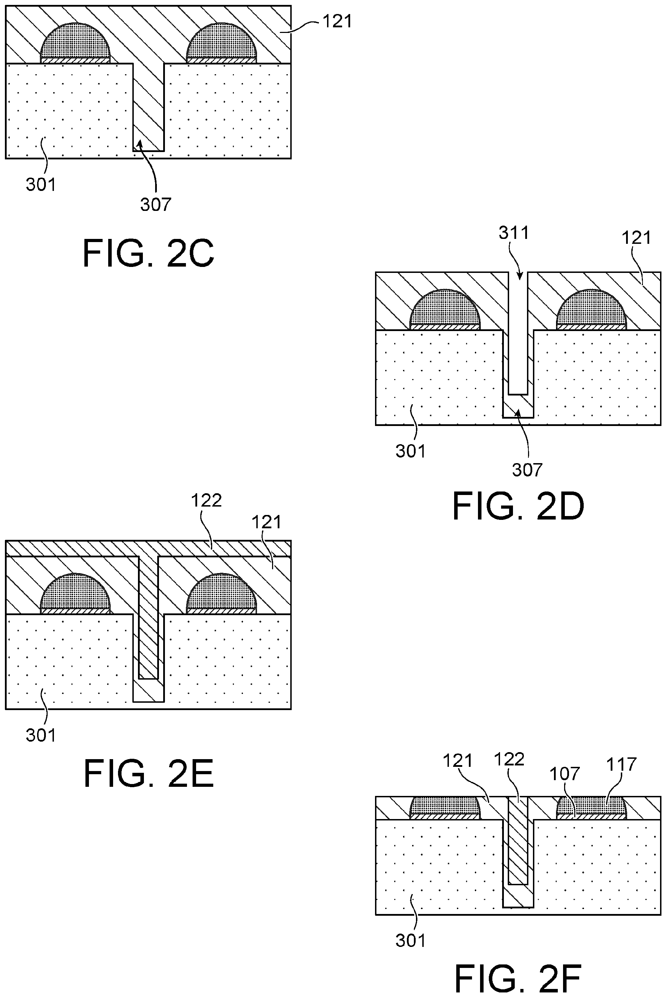

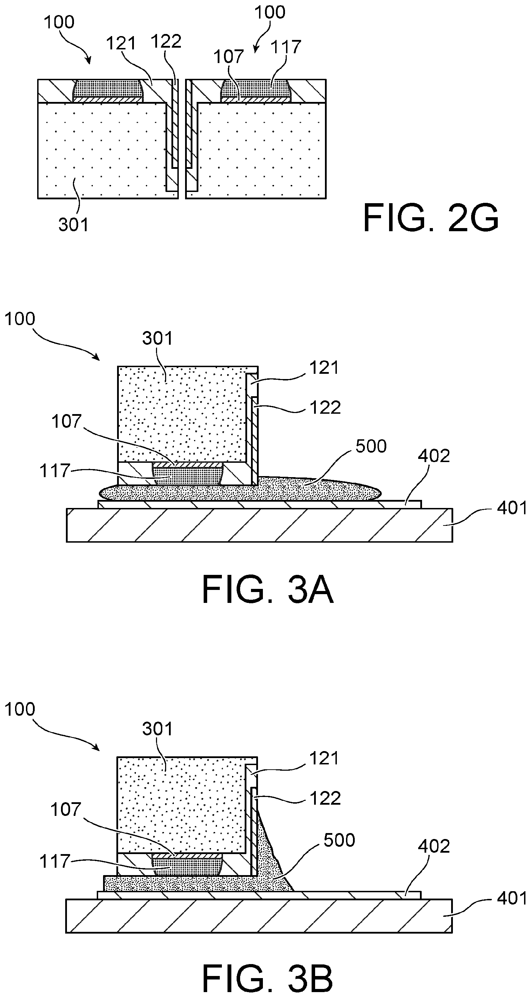

Plus particulièrement, le procédé comporte les étapes suivantes :
a) Fournir un substrat 301 dans lequel sont formées des puces 103, les puces 103 comprenant au moins deux plages de connexion 107, recouvertes par des plots de connexion 117, et disposées sur une première face principale 305 du substrat 301 (figure 2A),
b) Découper partiellement le substrat 301 entre les puces 103 de manière à former des cavités 307, les parois des cavités 307 correspondant aux parois latérales des puces 103 (figure 2B),
c) Déposer une couche de matériau isolant 121, moyennant quoi le matériau isolant 121 recouvre les plots métalliques 117, recouvre la première face 305 du substrat 301 entre les plots métalliques 107 et remplit les cavités 307 (figure 2C),
d) Retirer une partie du matériau isolant présent dans les cavités 307 de manière à former des tranchées 311 (figure 2D),
e) Déposer une couche de matériau conducteur 122 sur la couche de matériau isolant 121, le matériau conducteur remplissant les tranchées 311 (figure 2E),
f) Amincir le dispositif pour rendre accessible les plots de connexion 117 (figure 2F),
g) Séparer les composants 100 en découpant le substrat 301 à travers le matériau conducteur, moyennant quoi on obtient des composants à flancs mouillables 100 (figure 2G).

A l'étape a), la fabrication du ou des composants discrets et/ou circuits intégrés formant les composants 100 est achevée. Les composants 100 sont formées à partir d'un même substrat 301, et n'ont pas encore été individualisées. Les puces 103 sont délimitées par un trait pointillé dans le substrat 301. Le substrat 301 comprend une première face 305 (face supérieure ou face avant) et une deuxième face 303 (face arrière ou face inférieure).

Le substrat 301 est, par exemple, un substrat semiconducteur, par exemple en silicium.

Le substrat 301 a, par exemple, une épaisseur comprise entre 300 et 900 µm, par exemple une épaisseur d'environ 725 µm.

De plus, des plages de connexion électriques 107, décrits en relation avec la figure 1, ont été formés sur une face supérieure 305 du substrat 301 (figure 2A).

Les plages de connexion électriques 107 sont recouvertes par un plot métallique 117, pouvant notamment avoir la forme d'une bille (« bump » en terme anglo-saxon). Alternativement, il peut s'agir d'un élément conducteur ayant une autre forme, comme par exemple un pilier ou un cube.

Les plots métalliques 117 permettent une reprise directe du contact en face avant 115 du boîtier 119.

Les plots métalliques 117 sont, avantageusement, brasés sur les plages de connexion électrique 107. Par exemple les plots métalliques sont en un matériau brasable à base d'étain, typiquement SnAgCu.

Sur les figures, les puces 103 sont représentés avec des dimensions similaires. Mais selon une variante, elles peuvent avoir des dimensions différentes. Une plage de connexion électriques 107 est représentée pour une meilleure lisibilité, mais chaque puce 103 comprend au moins deux plots de connexion 107. La personne du métier saura adapter le procédé de fabrication décrit ici dans ce cas.

Lors de l'étape b), une étape de découpe partielle des composants 100 est opérée, par exemple par un procédé de découpe mécanique, comme un procédé de sciage. Ainsi, des cavités 307 définissant les contours latéraux des puces 103 des composants 100 sont formées dans le substrat 301. Plus particulièrement, les cavités 307 s'étendent depuis la face supérieure 305 du substrat 301. Selon un exemple, la profondeur des cavités 307 correspond à l'épaisseur voulue des puces des composants 100. Selon un exemple, la profondeur des cavités 307 est de l'ordre de 100 ou 300 µm. La profondeur peut être modifiée en fonction de l'application voulue.

Les cavités 307 formées à l'étape b) ont, de préférence, une épaisseur comprise entre 50 et 80 µm et une profondeur comprise entre 100 et 150pm. L'épaisseur peut être modifiée en fonction de l'application voulue.

Cette étape b) est réalisée au moyen d'un dispositif de découpe. Le dispositif de découpe est, par exemple, un outil de gravure mécanique comme une scie, ou un outil de gravure par un laser. Selon un mode de réalisation préféré, le dispositif de découpe est un laser.

Lors de l'étape c), les parois des cavités 307 sont recouvertes par un matériau isolant. Pour cela, une couche 121 de matériau isolant est déposée dans les cavités 307, sur la première face 305 du substrat 301 et sur les plots 117. Ainsi, les plots 117 sont disposés au sein du matériau isolant. La couche 121 forme une première partie du boîtier 109 des composants 100. Cette première partie du boîtier protège donc la face supérieure des composants 100, et au moins une partie des flancs des composants 100.

Lors de l'étape c), le matériau isolant peut être déposée au moyen d'une presse ou par moulage sous vide.

Le matériau isolant peut comprendre une résine isolante électriquement. Il peut s'agir d'une résine thermodurcissable ou une résine thermoplastique. Le matériau sera choisi de manière à ne pas être fusible sur la plage de température d'utilisation des composants électroniques. La résine peut être choisie parmi le groupe comprenant : les résines de type époxy, et les résines de type phénolique, les résines de type acrylique.

Le matériau isolant peut également comprendre des particules isolantes électriquement. Les particules sont, par exemple, des particules d'oxyde, et notamment des particules d'alumine ou de silice.

La polymérisation est, par exemple, une étape de polymérisation UV ou une polymérisation par activation thermique.

Un recuit peut être réalisé avant l'étape d).

Lors de l'étape d), une étape de découpe est mise en oeuvre pour former des tranchées 311 dans la couche de matériau isolant 121. Les tranchées 311 sont formées au niveau des cavités 307. Une partie du matériau isolant reste dans les cavités. Cette partie recouvre le fond et les parois latérales des cavités 307. Elle protège et isole électriquement le flanc des composants 100. Selon un exemple, l'épaisseur de matériau isolant restant sur les parois latérales des cavités 307 est comprise entre 5 et 20 µm, de préférence entre 5 et 10 µm. Le fond des cavités 307 peut être recouvert par une épaisseur de 1 à 10 µm de matériau isolant.

Les tranchées 311 sont réalisées au moyen d'un dispositif de découpe. Le dispositif de découpe est, par exemple, un outil de gravure mécanique comme une scie, ou un outil de gravure par un laser. Selon un mode de réalisation préféré, le dispositif de découpe est un laser.

Lors de l'étape e), une couche de matériau conducteur 122 est déposée sur la couche de matériau isolant 121. La couche de matériau conducteur 122 est déposée au moins dans les tranchées 311 de manière à recouvrir la couche de matériau isolant 121. Elle peut être déposée pleine plaque.

Le matériau conducteur est de préférence une résine conductrice électriquement. Plus particulièrement, la résine de la couche 122 comporte au moins un matériau de base auquel des particules métalliques recouvertes d'une couche de protection isolante électriquement sont ajoutés.

Le matériau de base assure l'adhésion de la couche 122 au matériau 121 et les particules assurent la mouillabilité finale de la couche 122.

Le matériau de base est choisi parmi le groupe comprenant : les résines de type époxy, et les résines de type phénolique, les résines de type acrylique. Les particules métalliques sont, par exemple, des particules métalliques dont le matériau est choisi parmi le groupe comprenant : le cuivre, un alliage comprenant du cuivre, le titane, un alliage comprenant du titane, du nickel, un alliage comprenant du nickel, de l'argent, et un alliage comprenant de l'argent.

Selon un mode de réalisation, la couche de résine conductrice 122 peut être déposée par impression (« screen printing ») ou par moulage sous vide.

La polymérisation est, par exemple, une étape de polymérisation UV ou par activation thermique.

Un recuit peut être réalisé après l'étape e) et avant l'étape f).

Le procédé comprend une étape f) d'amincissement en face avant pour rendre accessible les plots conducteurs 117. Les contacts du boîtier 109 des composants 100 sont alors complètement formés. L'étape d'amincissement en face avant peut être réalisée par polissage ('grinding').

Le procédé peut également comprendre une étape d'amincissement du substrat 301 en face arrière 303. Pour cela, la structure est retournée et fixée par sa face avant, c'est-à-dire la face 305. Le support est, par exemple, une bande de ruban adhésif. La structure est, ensuite, amincie par sa face arrière 303 de façon que le substrat 301 ait son épaisseur définitive. Selon un exemple, la structure 301 est amincie jusqu'à atteindre le fond des cavités 307.

Le procédé peut avantageusement comprendre une étape entre l'étape f) et l'étape g) au cours de laquelle, une couche isolante additionnelle est déposée sur la face arrière 303 de la structure pour former l'arrière 111 du boîtier des composants 100. Ainsi, toutes les faces du substrat 301 sont protégées soit par la couche 121 soit par la couche isolante additionnelle.

La couche isolante additionnelle est une couche en un matériau isolant électriquement, par exemple une résine, par exemple une résine du même type que la résine de la couche 121. Selon un autre exemple, les matériaux des couches sont différents.

Lors de l'étape g), les composants sont individualisés en réalisant une découpe à travers la résine conductrice 122. Les composants 100 sont ainsi séparés les uns des autres.

Les particules métalliques du matériau conducteur 122 sont alors exposées, assurant la fonction de mouillabilité des flancs 119 des composants électroniques 100.

Les composants 100 obtenus sont des composants à montage en surface (ou SMD pour « surface mouting device ») de type "flip-chip", c'est-à-dire qu'ils peuvent être fixés sur un support, par exemple, une carte de circuit imprimé, par leur face supérieure, c'est-à-dire la face sur laquelle sont disposés les contacts 117 du boîtier 109.

Les composants pourraient également être des composants de type DFN (« dual flat no-lead ») ou de type QFN (« quad flat no-lead »). Ces composants sont des composants qui n'ont pas de connexions débouchantes ("leads"). Ces dernières ne dépassent pas du corps en résine du boitier.

De tels composants sont particulièrement intéressants pour garantir la fiabilité des connexions électriques, une fois les circuits montés dans leur environnement.

Les figures 3A et 3B représentent des étapes d'un procédé pour assembler un composant 100 sur un dispositif externe, par exemple une carte de circuit imprimé ou un autre composant.

Le dispositif externe comprend un substrat 401 recouvert par des pistes 402.

Un matériau de brasage 500 est positionné entre le composant 100 et les pistes 402 dispositif externe 400 (figure 3A). Lors du brasage, le matériau de brasage 500 remonte le long des flancs mouillables 122 des composants, ce qui permet de vérifier que le brasage a été réalisé correctement.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication de composants électroniques (100) à flancs mouillables à partir d'un substrat (301) dans lequel sont formées des puces (103), les puces (103) comprenant au moins deux plages de connexion (107), recouvertes par des plots de connexion (117), et disposées sur une première face principale (305) du substrat (301), les puces (103) étant séparées par des cavités (307), le procédé comprenant les étapes suivantes :
- déposer une couche de matériau isolant (121) dans les cavités,
- déposer une couche de matériau conducteur (122) sur la couche de matériau isolant (121) afin de former des flancs mouillables,
- séparer les composants électroniques (100) en découpant le substrat (301) à travers la couche de matériau conducteur (122), moyennant quoi la puce (103) est protégée par un boîtier (109) dont les flancs comprennent successivement une couche de matériau isolant (121) et une couche de matériau conducteur (122), la couche de matériau conducteur (122) étant isolée électriquement des reprises de contact (117) par la couche de matériau isolant (121).

2. Procédé selon la revendication 1, dans lequel, lors de la première étape, la couche de matériau isolant (121) est déposée dans les cavités (307), sur les plots de connexion (117) et sur la première face du substrat (305).

3. Procédé selon la revendication 2, le procédé comprenant, avant la deuxième étape, une étape au cours de laquelle une partie du matériau isolant présente dans les cavités (307) est retirée, de manière à former des tranchées (311) dont le fond et les parois sont en résine isolante et dans lequel, lors de la deuxième étape, la couche de matériau conducteur (122) est déposée dans les tranchées (311).

4. Procédé selon les revendications 2 et 3, le procédé comprenant en outre les étapes suivantes :
- Amincir la couche de matériau isolant (121) pour rendre accessibles les plots métalliques (117),
- Séparer les composants électroniques (100) en découpant le substrat (301) à travers la couche de matériau conducteur (122).

5. Composant électronique (100) à flancs mouillables comprenant une puce (103) protégée par un boîtier (109) dont les flancs comprennent successivement une couche de matériau isolant (121) et une couche de matériau conducteur (122) .

6. Composant électronique (100) selon la revendication 5, comprenant une première face principale (115) comprenant au moins deux plots de connexion (117), une deuxième face principale (111) et des flancs (119), la couche de matériau conducteur (122) étant isolée électriquement des plots de connexion (117) par la couche de matériau isolant (121), la couche de matériau conducteur (122) s'étendant sur une portion des flancs (119) à partir de la première face principale (115).

7. Composant électronique selon l'une quelconque des revendications 5 et 6, dans lequel la couche de matériau isolant (121) recouvre une première face principale (105) de la puce (103) entre les plots de connexion (117).

8. Composant électronique selon l'une quelconque des revendications 5 à 7, dans lequel la couche de matériau isolant (121) est une couche de résine époxy ou phénolique dans laquelle sont dispersées des charges électriquement isolantes, par exemple des particules d'alumine.

9. Composant électronique selon l'une quelconque des revendications 5 à 8, dans lequel la couche de matériau conducteur (122) est une couche de résine époxy ou phénolique dans laquelle sont dispersées des charges électriquement conductrices, par exemple des particules d'argent, de cuivre ou de noir de carbone.
